(19) Europäisches Patentamt
European Patent Office
Office européen des brevets

(11) **EP 3 168 325 B1**

(12) **EUROPÄISCHE PATENTSCHRIFT**

(45) Veröffentlichungstag und Bekanntmachung des Hinweises auf die Patenterteilung:
**05.01.2022** **Patentblatt 2022/01**

(51) Int Cl.:
***C23C 14/34*** *(2006.01)*     ***C23C 14/18*** *(2006.01)*
***H01J 37/34*** *(2006.01)*     ***C22C 5/06*** *(2006.01)*

(21) Anmeldenummer: **15193862.8**

(22) Anmeldetag: **10.11.2015**

(54) **SPUTTERTARGET AUF DER BASIS EINER SILBERLEGIERUNG**

SILVER ALLOY BASED SPUTTER TARGET

CIBLE DE PULVERISATION A BASE D'UN ALLIAGE D'ARGENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**17.05.2017** **Patentblatt 2017/20**

(73) Patentinhaber: **Materion Advanced Materials Germany GmbH**
**63755 Alzenau (DE)**

(72) Erfinder:
* **SCHLOTT, Dr. Martin**
**63075 Offenbach (DE)**
* **SIMONS, Dr. Christoph**
**63599 Biebergemünd (DE)**
* **KASTNER, Albert**
**63547 Hanau (DE)**
* **WAGNER, Jens**
**60435 Frankfurt (DE)**
* **KONIETZKA, Uwe**
**63826 Geiselbach (DE)**

(74) Vertreter: **Kador & Partner PartG mbB**
**Corneliusstraße 15**
**80469 München (DE)**

(56) Entgegenhaltungen:
**EP-A1- 1 889 931**     **JP-A- 2004 002 929**
**US-A1- 2004 226 818**     **US-A1- 2006 169 577**
**US-A1- 2008 131 308**

* **None**

**Beschreibung**

Die vorliegende Erfindung betrifft ein Sputtertarget, das eine Silberlegierung zur Abscheidung agglomerationsbeständiger Schichten umfasst, sowie ein Herstellungsverfahren für dieses Sputtertarget.

Silber ist aufgrund seiner guten Reflexionseigenschaften ein gebräuchliches Beschichtungsmaterial im Bereich der optischen Datenspeicher, Display-Anwendungen und in der Optoelektronik. Abhängig von der Einsatzumgebung und weiteren angrenzenden Schichten neigt Silber zur Korrosion, was zur Beeinträchtigung der Reflexionseigenschaften und bis zum Ausfall des Bauteils führen kann.

Eine weitere Einschränkung der Anwendung erfahren Silberschichten, da erhöhte Temperaturen während der Abscheidung und/oder in nachfolgenden Prozessschritten (z.B. Temperaturen von mehr als 200°C) die optischen und/oder elektrischen Eigenschaften der Silberschicht durch Agglomeration erheblich schädigen können. Die Agglomeration zeigt sich durch einen sprunghaften Anstieg des Haze-Wertes (diffuse Lichtstreuung) sowie einen starken Abfall der Reflexion und der elektrischen Leitfähigkeit.

Es ist bekannt, dass die Korrosionseigenschaften verbessert werden können, wenn dem Silber Legierungselemente wie Indium, Wismut, Antimon oder Zinn zugegeben werden, siehe EP1489193. So beschreibt beispielsweise die EP 2487274 A1 eine

Silberlegierung, die bis zu 1,5 Gew% Indium enthält und eine mittlere Korngröße im Bereich von 150-400 $\mu$m aufweist. In der US 7,767,041 werden Wismut-haltige Silberlegierungen beschrieben.

JP 2000-109943 beschreibt Silberlegierungen, die 0.5-4.9 Atom% Palladium enthalten. US 2004/0048193 verbessert die Korrisionsstabilität durch Zugabe von Samarium.

EP 1 736 558 beschreibt eine Silberlegierung zur Verwendung als Reflexionsbeschichtung. Diese Silberlegierung enthält zumindest zwei Legierungselemente, wobei das erste Legierungselement Aluminium, Indium oder Zinn ist und das zweite Legierungselement aus einer Vielzahl weiterer metallischer Elemente ausgewählt werden kann.

Die Verbesserung der Agglomerationsbeständigkeit ist in US 7,413,618 durch Zugabe von Ga und Seltenerden, bzw. Cu, Sn gelöst. Durch Sputtern der bevorzugten Legierungszusammensetzung wird dabei eine Verbesserung der Korrosionsstabilität und Agglomerationsbeständigkeit erreicht.

Eine Verbesserung der Korrosions- und Temperaturstabilität gedruckter Leitpasten in Bezug auf den Widerstand wird durch Silberlegierungen erreicht, die u.a. Sn, Pb, Zn, In, Ga und als weiteres Element z.B. Al, Cu oder Titan enthalten, siehe US 2005/0019203. Weiterer relevanter Stand der Technik ist in dem Patentdokument US 2008/0131308 A1 genannt.

Für CD-"Recording-Layer" sind Lösungen zur Verbesserung der Agglomerationsbeständigkeit von Silberschichten bekannt. JP 2004-0002929  beschreibt Silber mit Ti, Zr, Hf, V, Nb, Ta, Cr, Mo, W, Fe, Ru, Co, Rh, Ir, Ni, Pd, Pt, Cu, Au, At, Zn, Al, Ga, In, Si, Ge, Sn (0,1-8 at%). EP 1889930, EP 1889931, EP 1889932 und EP 18889933 berichten von ähnlich umfangreichen Stoffsystemen bis 20 at% zur Verbesserung der Agglomerationsbeständigkeit. Ebenso beschreibt US 6,896,947 ein Schichtsystem für "Optical-Recording-Layer", das eine Silberlegierung enthält. US 5,853,872 verbessert v.a. durch Zulegieren von Refraktärmetallen die Agglomerationsbeständigkeit des Silbers, allerdings wird die Korrosionsstabilität nicht gezielt gesteuert. US 2007/0020138 verbessert die Agglomerationsbeständigkeit des Silbers durch Zugabe von Mo oder Ni und Indium.

Zusammenfassend lässt sich für die Zulegierungen feststellen, dass mit steigender Menge bestimmter Elemente einerseits die Korrosionsstabilität und Agglomerationsbeständigkeit zunehmen kann, andererseits nimmt auch das Risiko zu, dass die Reflexionseigenschaften nachteilig beeinflusst werden und die elektrische Leitfähigkeit sinkt. Bei Mehrfachstoffsystemen, insbesondere solchen, die keine Mischkristallbildung aufweisen, ist die gleichmässige Verteilung der Elemente wichtig.

Prinzipiell können solche Reflexionsschichten über unterschiedliche Beschichtungsverfahren auf ein Substrat aufgebracht werden. Ein bevorzugtes Verfahren ist Sputtern, wobei Sputtertargets eingesetzt werden. Wie dem Fachmann bekannt ist, versteht man unter einem Sputtertarget das zu sputternde Material einer Kathodenzerstäubungsanlage.

Bei der chemischen Zusammensetzung des Sputtertargets sind die erwünschten Eigenschaften der herzustellenden Beschichtung zu berücksichtigen. Soll beispielsweise eine Reflexionsbeschichtung auf Silberbasis mit hoher Korrosions- und Agglomerationsstabilität über den Sputterprozess hergestellt werden, so kann das Sputtertarget aus einer Silberlegierung mit korrosions- und agglomerationshemmenden Legierungselementen bestehen. Ein wichtiges Kriterium, das ein Sputtertarget üblicherweise erfüllen sollte, ist eine sehr gleichmäßige Sputterrate, um so die Bildung einer Beschichtung mit einer möglichst geringen Schichtdickenschwankung zu ermöglichen. Durch hohe Schichtdickenschwankungen wird unter anderem auch das Reflexionsverhalten einer Silberbeschichtung nachteilig beeinflusst. Vor allem bei dünnen Schichten, die auch eine Transparenz aufweisen sollen, sind eine hohe Schichtdickengleichmäßigkeit und damit ein homogenes Sputterverhalten wichtig. Außerdem wird durch gleichmäßiges Sputterverhalten eine hohe Targetausnutzung gefördert und somit die Prozesseffizienz erhöht.

Weiterhin sollte ein geeignetes Sputtertarget eine Abscheidung bei möglichst geringer Are-Rate ermöglichen.

Als "Arcing" werden lokale Funkentladungen auf dem Sputtertarget bezeichnet. Durch die Funkenentladung wird das Sputtertargetmaterial lokal aufgeschmolzen und kleine Spritzer dieses aufgeschmolzenen Materials können auf das zu beschichtende Substrat gelangen und dort Defekte erzeugen.

Somit muss das Sputtertargetmaterial so beschaffen sein, dass es einerseits den erwünschten Endeigenschaften der aufzubringenden Beschichtung Rechnung trägt (z.B. gute Reflexionseigenschaften oder Leitfähigkeit bei möglichst hoher Korrosions- und Agglomerationsstabilität), andererseits aber eine gleichmäßige Sputter-Rate, eine gleichmässige Schichtzusammensetzung und ein möglichst geringes Arcing aufweist, um die Schichtdickenschwankung und die Anzahl der Defekte in der Beschichtung zu minimieren. Eine Verbesserung des einen Aspekts (z.B. Optimierung der Schichteigenschaften hinsichtlich der geplanten Anwendung) sollte nicht auf Kosten des zweiten Aspekts (möglichst gute Sputtereigenschaften) erfolgen. In der Praxis zeigt sich aber häufig, dass es schwierig ist, beiden Aspekten gleichzeitig gerecht zu werden.

Eine Aufgabe der vorliegenden Erfindung besteht in der Bereitstellung eines Sputtertargets, mit dem sich eine möglichst alterungsbeständige und bei erhöhten Temperaturen agglomerationsbeständige Reflexionsbeschichtung auf Silberbasis mit geringer Schichtdickenschwankung und bei geringer Are-Rate herstellen lässt.

Eine weitere Aufgabe der vorliegenden Erfindung besteht in der Bereitstellung eines geeigneten Verfahrens für die Herstellung eines solchen Sputtertargets.

Gelöst wird die Aufgabe durch ein Sputtertarget gemäß Anspruch 1, umfassend eine Silberlegierung, die

- ein erstes Element, ausgewählt aus Indium, Zinn, Antimon und Wismut, in einer Menge von 0,01-2,0 Gew%, bezogen auf das Gesamtgewicht der Silberlegierung, und
- 0,01-2,0 Gew% Titan, bezogen auf das Gesamtgewicht der Silberlegierung, enthält, und
- eine mittlere Korngröße von maximal 55 $\mu$m aufweist.

Mit dem erfindungsgemäßen Sputtertarget lässt sich eine Reflexionsbeschichtung mit hoher Korrosionsstabilität herstellen. Im Rahmen der vorliegenden Erfindung wurde überraschend festgestellt, dass sich trotz des Titan-Anteils in der Silberlegierung des Sputtertargets sehr niedrige Arcing-Raten sowie eine sehr gleichmäßige Sputterrate und damit eine sehr geringe Schichtdickenschwankung in der abgeschiedenen Beschichtung realisieren lassen, wenn die Silberlegierung eine mittlere Korngröße von maximal 55 $\mu$m aufweist.

Bevorzugt weist die Silberlegierung des Sputtertargets eine mittlere Korngröße im Bereich von 1-55 $\mu$m, bevorzugter 3-50 $\mu$m, noch bevorzugter 5-45 $\mu$m oder 5-30 $\mu$m auf.

Bevorzugt enthält die Silberlegierung das Indium, Zinn, Antimon oder Wismut in einer Menge von 0,1-1,0 Gew% und Titan in einer Menge von 0,1-1,0 Gew%, jeweils bezogen auf das Gesamtgewicht der Silberlegierung. Optional kann die Silberlegierung noch ein oder mehrere zusätzliche Elemente enthalten, wobei diese zusätzlichen Elemente bevorzugt aus Indium, Zinn, Antimon oder Wismut ausgewählt sind, mit der Maßgabe, dass sich das zusätzliche Element von dem ersten Element unterscheidet. Sofern eines dieser zusätzlichen Elemente anwesend ist, liegt es bevorzugt in einer Menge von 0,01-2,0 Gew% vor, bezogen auf das Gesamtgewicht der Silberlegierung. Sofern zwei oder mehr dieser zusätzlichen Elemente anwesend sind, kann es bevorzugt sein, dass deren Gesamtmenge im Bereich von 0,01-4,0 Gew%, bevorzugter 0,01-2,0 Gew% liegt, bezogen auf das Gesamtgewicht der Silberlegierung.

Die Silberlegierung enthält nur die oben beschriebenen

Legierungselemente und der Rest sind Silber und unvermeidliche Verunreinigungen. Für die Indium-haltige Silberlegierung ist es also bevorzugt, dass diese Indium und Titan und optional eines oder mehrere der Elemente Bi, Sb und Sn enthält und der Rest Silber und unvermeidliche Verunreinigungen sind.

Für die Antimon-haltige Silberlegierung ist es also bevorzugt, dass diese Antimon und Titan und optional eines oder mehrere der Elemente Bi, In und Sn enthält und der Rest Silber und unvermeidliche Verunreinigungen sind.

Für die Wismuth-haltige Silberlegierung ist es also bevorzugt, dass diese Wismuth und Titan und optional eines oder mehrere der Elemente Sb, In und Sn enthält und der Rest Silber und unvermeidliche Verunreinigungen sind.

Für die Zinn-haltige Silberlegierung ist es also bevorzugt, dass diese Zinn und Titan und optional eines oder mehrere der Elemente Sb, In und Bi enthält und der Rest Silber und unvermeidliche Verunreinigungen sind.

Bei diesen unvermeidlichen Verunreinigungen kann es sich um metallische Verunreinigungen handeln.

Bevorzugt werden die unvermeidlichen Verunreinigungen so gering wie möglich gehalten und liegen in Summe bevorzugt in einer Menge von weniger als 0,5Gew%, bevorzugter weniger als 0,05 Gew% vor. Dies kann beispielsweise sichergestellt werden, wenn bereits die Ausgangsmetalle, die für die Herstellung der Silberlegierung eingesetzt werden, eine ausreichend hohe Reinheit aufweisen. Die Mengenangaben beziehen sich auf das Gesamtgewicht der Silberlegierung.

Die Sputtereigenschaften der Silberlegierung können weiter optimiert werden, wenn die Körner der Silberlegierung ein bestimmtes Achsenverhältnis aufweisen. In einer bevorzugten Ausführungsform weisen die Körner der Silberlegierung ein bevorzugtes mittleres Achsenverhältnis von mindestens 40% bis maximal 100% auf. Eine weitere Optimierung der Sputtereigenschaften der Silberlegierung kann außerdem erzielt werden, wenn die Körner der Silberlegierung eine möglichst geringe Variation der Korngröße aufweisen. Bevorzugt weist die Silberlegierung des Sputtertargets eine Variation der Korngröße von weniger als 33%, bevorzugter weniger als 15%, noch bevorzugter weniger als 12% auf.

Da die Silberlegierung des Sputtertargets ein kristallines Material ist, zeigen sich in der Röntgenbeugung entsprechend Röntgenbeugungsreflexe. Die Intensität der jeweiligen Röntgenbeugungsreflexe beschreibt Vorzugsorientierungen im Kristallgitter und Texturen der Legierung. In einer bevorzugten Ausführungsform beträgt die Variation des Verhältnisses der Intensität des zweitintensivsten Röntgenbeugungsreflexes zu der Intensität des intensivsten

Röntgenbeugungsreflexes weniger als 35%. Es hat sich gezeigt, dass Silber-Indium-Titanlegierungen, die dieser Bedingung genügen, für eine gleichmäßige Sputterrate sehr vorteilhaft sind.

In der Silberlegierung des erfindungsgemäßen Sputtertargets liegen Ti-haltige Einschlüsse vor. Diese Einschlüsse liegen in Form einer gesonderten Phase vor. In diesem Fall handelt es sich bei der Silberlegierung um eine mehrphasige Legierung. Eine solche mehrphasige Legierung wird durch eine Matrixphase, die Silber, das erste Element (In, Sb, Sn oder Bi) und optional Ti sowie optional eines oder mehrere der zusätzlichen Elemente enthält, und in dieser Matrix verteilten Ti-haltige Einschlüsse gebildet. Wie oben beschrieben, enthält die Silberlegierung des Sputtertargets das Titan in einer Menge von 0,01-2,0 Gew%. Sofern die Silberlegierung Ti-haltige Einschlüsse enthält, kann das Titan der Silberlegierung sowohl in der Matrixphase (d.h. zusammen mit Ag und In (alternativ: Bi, Sb oder Sn) die Matrix bildend) als auch in den Einschlüssen vorliegen. Alternativ ist es auch möglich, dass das Titan der Silberlegierung nur in den Einschlüssen vorliegt. Die Ti-haltigen Einschlüsse können optional als weiteres metallisches Element noch Ag enthalten, beispielsweise in Form einer Ag-Ti-Legierung oder einer intermetallischen Verbindung (z.B. TiAg). Bei den Ti-haltigen Einschlüssen kann es sich um rein metallische Einschlüsse handeln. Alternativ können die Einschlüsse Ti-haltige Verbindungen, beispielsweise in Form von Oxiden oder Nitriden, enthalten (d.h. Ti-haltige Einschlüsse, die teilweise oder vollständig oxidiert oder nitridiert sind). Sofern Ti-haltige Einschlüsse vorhanden sind, beträgt deren Anzahl pro $\mu$m$^2$ bevorzugt 0,1-5.

Die Ti-haltigen Einschlüsse weisen eine mittlere Größe kleiner 5 $\mu$m, bevorzugter kleiner 2 $\mu$m auf.

Die Silberlegierung enthält die oben beschriebenen Ti-haltigen Einschlüsse und liegt somit bevorzugt mehrphasig vor (d.h. Matrixphase mit darin dispergierten Ti-haltigen Einschlüssen).

Bevorzugt besteht das Sputtertarget aus der oben beschriebenen Silberlegierung.

Je nach Anwendung kann die Geometrie des Sputtertargets variieren. Das Sputtertarget kann beispielsweise planar (z.B. in Form einer runden Scheibe oder einer vieleckigen Platte), zylindrisch oder rohrförmig sein.

In Abhängigkeit von der geplanten Anwendung können auch die Abmessungen des Sputtertargets über einen breiten Bereich variieren. Beispielsweise kann das planare Sputtertarget eine Fläche im Bereich von 0,5 m$^2$ bis 8 m$^2$ aufweisen. Das rohrförmige Sputtertarget kann beispielsweise eine Länge im Bereich von 0,5 bis 4 m aufweisen.

Sofern erforderlich, kann das Sputtertarget noch auf einem Substrat angebracht werden, z.B. auf einer Rückplatte. Die Anbindung ("bonding") des Sputtertargets an das Substrat kann beispielsweise mittels Lot (z.B. Indium) erfolgen. Auch formschlüssiges Anbringen auf einer Rückplatte ist möglich. Dies ist dem Fachmann grundsätzlich bekannt.

In einem weiteren Aspekt betrifft die vorliegende Erfindung ein Verfahren zur Herstellung des oben beschriebenen Sputtertargets, in dem man eine Schmelze, die Silber, Titan und das erste Element, das aus Indium, Antimon, Zinn und Wismut ausgewählt ist, enthält, erstarren lässt, um einen Formkörper zu erhalten, der Formkörper auf eine Umformtemperatur von mindestens 200°C erwärmt wird und dann mindestens einem Umformschritt unterzogen wird, und der Formkörper außerdem mindestens einer Rekristallisation unterzogen wird.

Wie oben bereits erwähnt, kann optional noch mindestens ein zusätzliches Element, das aus Indium, Wismut, Zinn oder Antimon ausgewählt ist, zugegeben werden.

Die Schmelze kann über gängige, dem Fachmann bekannte Verfahren erzeugt werden, beispielsweise in einem Induktionsschmelzofen (z.B. in einem Vakuuminduktionsschmelzofen). Hierzu können die Metalle in geeigneten Mengenanteile in den Schmelzofen gegeben und aufgeschmolzen werden. Um die Menge an unerwünschten Verunreinigungen möglichst gering zu halten, kann es vorteilhaft sein, die Ausgangsmetalle bereits in ausreichend hoher Reinheit einzusetzen, beispielsweise von mindestens 99,5%. Der Schmelzvorgang wird üblicherweise unter Vakuum und/oder einer Inertgasatmosphäre (z.B. Argon) durchgeführt.

Anschließend kann die Schmelze in eine Form bzw. Kokille (z.B. eine Graphitform) gegossen werden. Lässt man die Schmelze in dieser Form abkühlen und erstarren, erhält man einen festen Formkörper.

Wie oben erwähnt, wird der Formkörper auf eine Umformtemperatur von mindestens 200°C erwärmt und dann mindestens einem Umformschritt unterzogen. Außerdem wird der Formkörper mindestens einer Rekristallisation unterzogen. Wie nachfolgend eingehender beschrieben wird, kann die Rekristallisation während des Umformens erfolgen. Es ist aber auch möglich, dass die Rekristallisation nach dem Umformen durchgeführt wird. Weiterhin ist möglich, dass sowohl während des Umformens als auch nach dem Umformen eine Rekristallisation durchgeführt wird.

Das Umformen kann beispielsweise durch Walzen, Schmieden, Stauchen, Strecken, Extrusion oder Pressen oder eine Kombination von zwei oder mehr dieser Umformprozesse erfolgen. Diese Umformprozesse sind dem Fachmann an sich bekannt.

Prinzipiell ist es im Rahmen des erfindungsgemäßen Verfahrens möglich, dass das Umformen nur in einem einzigen Umformschritt (z.B. Walzschritt) erfolgt. Alternativ kann es bevorzugt sein, dass mindestens zwei, bevorzugter mindestens 4 Umformschritte (bevorzugt Walzschritte) durchgeführt werden, z.B. 2-20 oder auch 8-15 Umformschritte (bevorzugt Walzschritte).

Werden zwei oder mehr Walzschritte durchgeführt, kann die Walzrichtung in jedem nachfolgenden Walzschritt der Walzrichtung des vorhergehenden Walzschritts entsprechen oder um etwa 180°C gedreht sein. Alternativ ist es auch möglich, dass im Fall von zwei oder mehr Walzschritten ein Kreuzwalzen erfolgt, d.h. in jedem nachfolgenden Walzschritt wird die Walzrichtung gegenüber dem vorangegangenen Walzschritt jeweils um etwa 90° gedreht (entweder jeweils im Uhrzeigersinn oder jeweils entgegen dem Uhrzeigersinn). Es ist auch möglich, dass die Walzrichtung in jedem Walzschritt gegenüber dem vorangegangenen Walzschritt jeweils um etwa 360°/n gedreht wird (entweder jeweils im Uhrzeigersinn oder jeweils entgegen dem Uhrzeigersinn), wobei n die Anzahl der Walzschritte ist.

Im Rahmen der vorliegenden Erfindung hat es sich als vorteilhaft erwiesen, wenn jeder Umformschritt bevorzugt bei einer Umformrate $\varepsilon$ von mindestens 1 $s^{-1}$ durchgeführt wird. Die Obergrenze der Umformrate ist nicht kritisch. Allerdings kann es aus prozesstechnischen Gründen vorteilhaft sein, wenn die Umformrate einen Wert von 20 $s^{-1}$ oder auch 15 $s^{-1}$ nicht übersteigt.

Wie dem Fachmann bekannt ist, berechnet sich die Umformrate gemäß der folgenden Gleichung:

$$\varepsilon = \frac{2\pi\,n}{60\sqrt{r'}} \cdot \sqrt{\frac{R}{H_0}} \cdot \ln\left(\frac{1}{1-r'}\right)$$

wobei

n die Umdrehungsgeschwindigkeit der Walze,
$H_0$ die Dicke des Formkörpers vor dem Walzschritt,
r' = r/100 mit r= Reduktion der Dicke des Formkörpers pro Walzschritt und
R der Walzenradius

sind.

Aufgrund seines Fachwissens kann der Fachmann daher ohne weiteres einen Walzschritt so ausführen, dass eine vorgegebene Umformrate realisiert wird, indem die Dickenreduktion pro Walzschritt vorgegeben wird.

In dem erfindungsgemäßen Verfahren wird der Formkörper mindestens einer Rekristallisation unterzogen. Es kann sich dabei um eine dynamische oder statische Rekristallisation handeln. Wie dem Fachmann bekannt ist, erfolgt eine dynamische Rekristallisation während des Umformens. Während der statischen Rekristallisation erfolgt keine Umformung. Die Bestimmung der Rekristallisationstemperatur einer gegebenen Legierung unter bestimmten Verfahrensbedingungen ist für den Fachmann auf der Basis seines allgemeinen Fachwissens ohne weiteres möglich.

Bevorzugt wird der Formkörper mindestens einer dynamischen Rekristallisation (d.h. während des Umformens, also während der Formkörper einem oder mehrerer Umformschritte unterzogen wird) und mindestens einer statischen Rekristallisation unterzogen.

Bevorzugt beträgt die Umformtemperatur, auf die der Formkörper vor dem Umformen erwärmt wird, mindestens 600°C, besonders bevorzugt mindestens 750°C oder sogar mindestens 900°C. Im Rahmen der vorliegenden Erfindung kann der Formkörper auch während des Umformens weiter aktiv (z.B. durch eine externe Wärmequelle) erwärmt werden. Wenn der Formkörper beim Umformen aber nicht signifikant abkühlt, ist ein weiteres aktives Erwärmen durch eine externe Wärmequelle während der Umformschritte nicht erforderlich.

Prinzipiell kann das erfindungsgemäße Verfahren auch einen oder mehrere Kaltumformungsschritte umfassen. Alternativ ist es möglich, dass das erfindungsgemäße Verfahren keine Kaltumformung umfasst.

Bevorzugt findet die statische Rekristallisation nach dem Umformen durch ein Glühen des umgeformten Formkörpers statt. Bevorzugt beträgt die Glühtemperatur mindestens 600°C, besonders bevorzugt mindestens 750°C oder sogar mindestens 900°C. Die Zeitdauer des Glühens kann über einen breiten Bereich variieren. Beispielhaft kann eine Glühdauer von 0,5 bis 5 Stunden genannt werden.

Das Umformen und, sofern durchgeführt, die statische Rekristallisation nach dem Umformen können unter Vakuum, in einer Inertgasatmosphäre (z.B. Stickstoff) oder auch an Luft erfolgen.

Nach der statischen Rekristallisation (z.B. durch das oben beschriebene Glühen) kann man den Formkörper abkühlen lassen. Alternativ kann es bevorzugt sein, dass der Formkörper nach der statischen Rekristallisation abgeschreckt wird, beispielsweise durch Eintauchen in ein Wasserbad oder Öl.

In einem weiteren Aspekt betrifft die vorliegende Offenbarung die Verwendung des oben beschriebenen Sputtertargets für die Herstellung einer Reflexionsschicht.

Es kann sich beispielsweise um die Reflexionsschicht in einem Display bzw. Bildschirm handeln. Aufgrund der hohen Qualität und sehr geringen Schichtdickenschwankung kann die Reflexionsschicht auch in flexiblen Displays bzw. Bildschirmen eingesetzt werden.

Anhand der nachfolgenden Beispiele wird die Erfindung eingehender erläutert.

**Beizpiele**

**I. Messmethoden**

Die Parameter, auf die in der vorliegenden Anmeldung Bezug genommen wird, werden mit den folgenden Messmethoden bestimmt. Für die optischen Bestimmungen mittels REM und Lichtmikroskop wurden die Proben in einem Harz eingebettet und metallografisch angeschliffen mit feiner werdender Körnung von 120 bis 4000 und abschliessend mit Diamantpaste auf poliert. Die Proben wurden anschließend an der Oberfläche mit Wasserstoffperoxid/Ammoniak bei 25°C für 60s geätzt.

Mittlere Korngröße und mittlere Größe der Ti-haltigen Einschlüsse

Die mittlere Korngröße M wurde im Linienschnittverfahren (DIN EN ISO 643) nach folgender Gleichung bestimmt:

$$M = (L*p)/(N*m)$$

wobei

    L: Länge der Messlinie
    p: Zahl der Messlinien
    N: Zahl der geschnittenen Körper
    m: Vergrößerung

Die Werte wurden an 3*3=9 verschiedenen Messstellen ermittelt in jeweils 3 Tiefen (dazu wurden von den Targets die entsprechenden Materialmengen abgeschliffen): 0 mm, 3 mm und 6 mm. Im Anschluss wird das arithmetische Mittel aus den 9 Messergebnissen gebildet.

Die mittlere Größe der Ti-haltigen Einschlüsse wurde ebenfalls nach dem oben beschriebenen Linienschnittverfahren bestimmt.

Variation der Korngröße

Aus den Korngrössen M kann die Variation gemäß den beiden folgenden Gleichungen (als Wert A1 oder alternativ als Wert B1) bestimmt werden:

$$A1 = (M_{max} - M_{ave})/(M_{ave} * 100)$$

$$B1 = (M_{ave} - M_{min})/(M_{ave} * 100)$$

mit

    $M_{max}$: Maximaler Wert der Korngrößen aller Messungen
    $M_{min}$: Minimaler Wert der Korngrößen aller Messungen
    $M_{ave}$: Mittlere Korngröße aller Messungen

Im Rahmen der vorliegenden Anmeldung wird der höhere der beiden Werte (A1 oder B1) für die Festlegung der Obergrenze der Korngrößenvariation herangezogen.

Mittleres Achsenverhältnis (in %) der Körner

Für die Bestimmung des mittleren Korn-Achsenverhältnisses werden Höhe (maximale Abmessung eines Korns in Dickenrichtung (d.h. senkrecht zur Sputteroberfläche) des Sputtertargets) und Breite (maximale Abmessung eines Korns senkrecht zur Dickenrichtung bzw. parallel zur Sputteroberfläche) von Körnern bestimmt. Es wird für die Körner jeweils der Quotientenwert von Korn-Höhe zu Korn-Breite und schließlich der Mittelwert dieser Quotientenwerte errechnet.

Bei der Bestimmung von Höhe und Breite von Körnern wird folgendermaßen vorgegangen: Von dem Sputtertarget wird ein Schliff senkrecht zur Sputteroberfläche angefertigt. Auf diesem Schliff werden mindestens zwei zufällige Flächen mit jeweils mindestens 40 Körnern ausgewählt. Für jedes dieser Körner wird dessen Höhe (d.h. maximale Abmessung) sowie dessen Breite (d.h. minimale Abmessung) bestimmt. Dies erfolgte mit einem Lichtmikroskop (Olympus PMG3) mit Grössenskala. Der Quotientenwert aus Höhe und Breite wird für jedes der Körner gebildet. Aus diesen Quotientenwerten wird der Mittelwert berechnet.

Verteilung der Ti-haltigen Einschlüsse

Die Bestimmung der Anzahl der Ti-haltigen Einschlüsse wurde an 4 verschiedenen Stellen des Targets mittels geätzten Anschliffen vorgenommen. Dazu wurde das sogenannte Flächenauszählverfahren (DIN EN ISO 643) angewandt. In den Flächen wurde unter dem Lichtmikroskop (Olympus PMG3) die Anzahl der Titankörner innerhalb einer Fläche von 50*50 $\mu m^2$ auf lichtmikroskopischen Aufnahmen ausgezählt. Die gewählte Vergrößerung war 500 fach. Die Kornanzahl wurde pro Bildausschnitt pro $\mu m^2$ umgerechnet und über 10 verschiedenen Probenstellen als arithmetischer Mittelwert mit Standardabweichung ausgedrückt.

Variation des Intensitätsverhältnisses zwischen dem zweitintensivsten Röntgenbeugungsreflex und dem intensivsten Röntgenbeugungsreflex

Am Sputtertarget werden an 5 verschiedenen Stellen Röntgenbeugungsmessungen vorgenommen mit einem Zweikreis Goniometer Stadi P der Fa. Stoe im Transmissionsmodus mit Röntgenstrahlen CuK alpha 1 zwischen 2 Theta 10-105°, Schrittweite 0,03°, Messfläche ca. 10 mm$^2$.

Für jede Röntgenbeugungsmessung werden die Intensität $I_2$ (nach Peakhöhe) des zweitintensivsten Beugungsreflexes und die Intensität $I_1$ (Peakhöhe) des intensivsten Beugungsrelexes bestimmt und aus diesen Werten das Intensitätsverhältnis $R=I_2/I_1$ gebildet. Im Anschluss wird das arithmetische Mittel aus den 5 Messergebnissen gebildet.

Die Variation des Intensitätsverhältnisses kann gemäß den beiden folgenden Gleichungen (als Wert A2 oder alternativ als Wert B2) bestimmt werden:

$$A2 = (R_{max} - R_{ave})/(R_{ave} * 100)$$

$$B2 = (R_{ave} - R_{min})/(R_{ave} * 100)$$

mit

$R_{max}$: Maximaler Wert der Intensitätsverhältnisse
$R_{min}$: Minimaler Wert der Intensitätsverhältnisse
$R_{ave}$: Mittelwert der Intensitätsverhältniswerte R

Im Rahmen der vorliegenden Anmeldung wird der höhere der beiden Werte (A2 oder B2) für die Festlegung der Variation des Röntgenbeugungsintensitätsverhältnisses herangezogen.

Optische Reflexion der durch Sputtern abgeschiedenen Schicht

Die Messung der direkten Reflektion (Einfallswinkel und Ausfallswinkel gleich) vor und nach Auslagerung bei 300°C, 30 min unter Stickstoff (Ofen Nabertherm N 150) erfolgte an den beschichteten Glassubstraten mittels Perkin Elmer Lambda 35.

Schichtdicke der durch Sputtern abgeschiedenen Schicht

Die Messung der Schichtdicken erfolgte mit Stylus-type Profilometer, z.B. Ambios Technology XP-200. Die Probenvorbereitung wurde durch Teilabdeckung des Sustrates mit einen Kaptonband durchgeführt, der entsprechend abgedeckte Bereich wird nicht besputtert. Nach dem Entfernen der Abdeckung kann die Schichtdicke an der entstandenen Stufe zwischen beschichteten und unbeschichteten Bereich ermittelt. Die Diamantnadel des Messgerätes misst über die Auslenkung die Schichtdicke. Gerätekalibration auf 10 $\mu$m erfolgte an mitgeliefertem Standard. Die Messung wurde an 10 verschiedenen Stellen der Probe wiederholt und der Mittelwert gebildet.

Auslagerung zur Bestimmung des Flächenwiderstandes

Zur Vermessung der Auslagerungsstabilität bzw. Agglomerationsbeständigkeit bei thermischer Belastung der mit den Targets der verschiedenen Beispiele gesputterten Schichten wurden mit 35 nm beschichtete Glassubstrate in einem Ofen Nabertherm N150 an Luft gealtert. Die Alterung erfolgte bei Temperaturen zwischen 100 und 300°C in 10° Schritten. Dazu wurden die Proben jeweils 10 min pro Temperaturschritt an Luft in den auf die entsprechende Temperatur vorgewärmten Ofen gelegt. Der Messschritt wurde immer an der gleichen Probe durchgeführt. Die Vorwärmung des Ofens erfolgte für mindestens 30 min, um Temperaturkonstanz zu erreichen, erst danach wurde die Probe in den Ofen gelegt. Nach der Entnahme aus dem Ofen wurden die Proben auf einer $Al_2O_3$-Platte abgekühlt.

Auslagerung zur Bestimmung der direkten Reflexion

Zur Vermessung der Auslagerungsstabilität der mit den Targets der verschiedenen Beispiele gesputterten Schichten wurden mit 35 nm beschichtete Glassubstrate in einem Ofen Nabertherm N150 unter Stickstoff bei 300° gealtert. Die Proben wurden in den vorgeheizten Ofen beschickt und 30 min gealtert. Nach der Entnahme aus dem Ofen wurden die Proben auf einer $Al_2O_3$-Platte an Luft abgekühlt.

Spezifischer Flächenwiderstand:

Die Messung des spezifischen Flächenwiderstandes der an Luft ausgelagerten Proben erfolgte an einem Vierspitzenmessplatz der Fa. Nagy, Typ SD 510 bei Raumtemperatur an jeweils 10 Proben. Es wurde das arithmetische Mittel bestimmt.

Menge an In, Bi, Sb, Sn, Ti in der Silberlegierung

Der jeweilige Gehalt dieser Elemente in der Silberlegierung kann durch ICP-OEC bestimmt werden.

**II. Herstellung von Sputtertargets**

Beispiel 1: Herstellung eines Sputtertargets bestehend aus einer Silberlegierung mit 0,5 Gew% Indium und 0,14 Gew% Titan

Silber, Indium und Titan, jeweils mit einer Reinheit von 99,9%, wurden in Mengen entsprechend der vorgegebenen Endzusammensetzung in einen VakuumInduktionsschmelzofen gegeben und bei 1200°C und 10$^{-1}$ mbar erschmolzen (Einwaagemasse: 950 kg). Die Schmelze wurde in eine Stahlguss-Kokille abgegossen und man ließ die Schmelze erstarren.
Der erhaltene Formkörper wurde auf 750°C (1 Stunde) vorgewärmt. Die Umformung erfolgte in 13 Walzschritten gemäß Tabelle 1. Die Dicke des Formkörpers vor dem Walzen und nach jedem Walzschritt sowie die jeweilige Dickenreduktion und Umformrate sind beispielhaft für die Walzschritte 1-4 und 10-13 in der Tabelle 1 angegeben. Die Umformraten für die jeweiligen Walzschritte 1-13 lagen im Bereich von 1,3-2,6 s$^{-1}$. Der Gesamtumformungsgrad betrug 87%.

Tabelle 1: Dicke, Dickenreduktion und Umformrate in Beispiel 1

| Walzschritt | Dicke [mm] | Dickenreduktion [mm] | Dickenreduktion [%] | Umform-rate [1/s] |
|---|---|---|---|---|
| 0 (d.h. vor dem Walzen) | 155 | 0 | 0 | |
| 1 | 128 | 27 | 17,4 | 1,3 |
| 2 | 105 | 23 | 18,0 | 1,5 |

(fortgesetzt)

| Walzschritt | Dicke [mm] | Dickenreduktion [mm] | Dickenreduktion [%] | Umform-rate [1/s] |
|---|---|---|---|---|
| 0 (d.h. vor dem Walzen) | 155 | 0 | 0 | |
| 3 | 86 | 19 | 18,1 | 1,6 |
| 4 | 70 | 16 | 18,6 | 1,8 |
| 10 | 26 | 4 | 13,3 | 2,6 |
| 11 | 23 | 3 | 11,5 | 2,6 |
| 12 | 21 | 2 | 8,7 | 2,3 |
| 13 | 20 | 1 | 4,7 | 1,7 |

Wie bereits oben erwähnt, berechnet sich die Umformrate in bekannter Weise gemäß der folgenden Gleichung:

$$\varepsilon = \frac{2\pi\,n}{60\sqrt{r'}} \cdot \sqrt{\frac{R}{H_0}} \cdot \ln\left(\frac{1}{1-r'}\right)$$

wobei

n die Umdrehungsgeschwindigkeit der Walze,
$H_0$ die Dicke des Formkörpers vor dem Walzschritt,
r' = r/100 mit r= Reduktion der Dicke des Formkörpers pro Walzschritt und
R der Walzenradius

sind.

In Beispiel 1 ergaben sich bei einer Walzengeschwindigkeit von 15 U/min und einem Walzenradius von 1050 mm Umformraten für die jeweiligen Walzschritte 1-13 von 1,3-2,6 s$^{-1}$. Die Umformgrade der jeweiligen Walzschritte lagen im Bereich von 5-18%.

Nach dem letzten Walzschritt erhielt man eine Platte von ca. 2000*2000*20 mm. Diese Platte wurde zur Rekristallisation bei 800°C/2 Stunden lang geglüht.

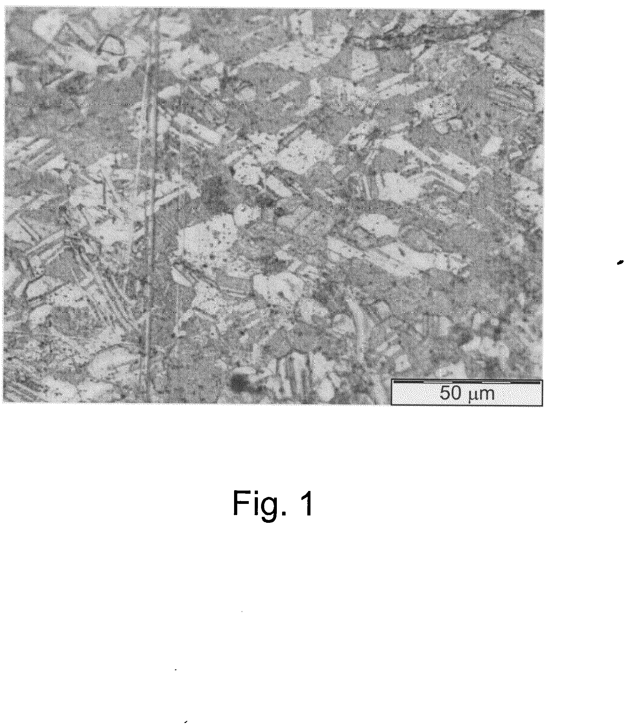

Figur 1 zeigt eine lichtmikroskopische Aufnahme der Silberlegierung nach Ätzen, Vergrößerung 500fach, (Schliff senkrecht zur Sputteroberfläche).

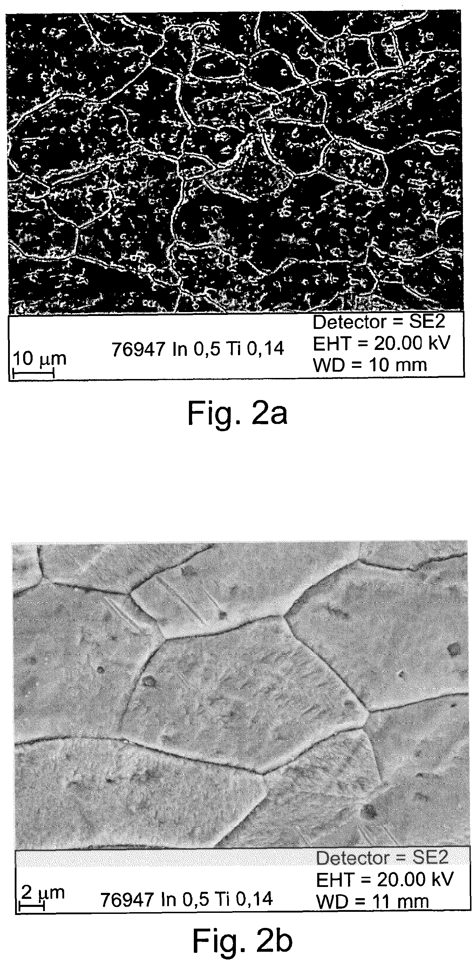

Die Figuren 2a und 2b zeigen in unterschiedlichen Vergrößerungen jeweils eine REM-Aufnahme der Silberlegierung nach dem Ätzen. Auf den Aufnahmen sind die Ti-haltigen Einschlüsse in Form dunkler Punkte erkennbar. Wie die REM-Aufnahmen belegen, weisen die Ti-haltigen Einschlüsse eine sehr geringe mittlere Größe auf und sind sehr gleichmäßig in der Silberlegierung verteilt.

In der Tabelle 2 sind Röntgenbeugungsreflexintensitäten verschiedener Netzebenen für die Silberlegierung sowie für Silber als Referenzmaterial aufgelistet.

Tabelle 2 Intensitäten der Netzebenenreflexe AgIn0,5Ti0,14

| Netzebene | 2 Theta (in Grad) | Silber (Soll) | AgIn0,5Ti0,14 |
|---|---|---|---|
| 111 | 38,12 | 100 | 100 |
| 200 | 44,28 | 40 | 19,5 |
| 220 | 64,43 | 25 | 23,7 |
| 311 | 77,48 | 26 | 10,0 |
| 222 | 81,54 | 12 | 8,0 |

Die Silberlegierung wies folgende Eigenschaften auf:

Mittlere Korngröße:         8 $\mu$m

(fortgesetzt)

| | |
|---|---|
| Mittleres Achsenverhältnis der Körner: | 41% |
| Variation der Korngröße: | 10,1 % |
| Variation des Intensitätsverhältnisses zwischen dem zweitintensivsten Beugungsreflex und dem intensivsten Beugungsreflex: | 19,5% |
| Mittelwert der Titaneinschlüsse: | 0,3+/-0,1 Einschlüsse/$\mu$m$^2$ |

Abschließend wurde ein Stück der gewalzten Platte für einen Sputterversuch mechanisch bearbeitet (Fräsen) und mit Indium gebondet (488*80*10mm$^3$). Die Bondung erfolgt auf Indium-vorbenetzter Kupferplatte. Die Targetrückseite wurde mit einer Rückseitenmetallisierung Cr/NiV/Ag versehen.

Beispiel 2: Herstellung eines Sputtertargets bestehend aus einer Silberlegierung mit 0,17 Gew% Indium und 0,32 Gew% Titan

Verfahrenstechnisch wurde Beispiel 2 genau wie Beispiel 1 hergestellt, abweichend sind nur die Mengen der Legierungselemente.

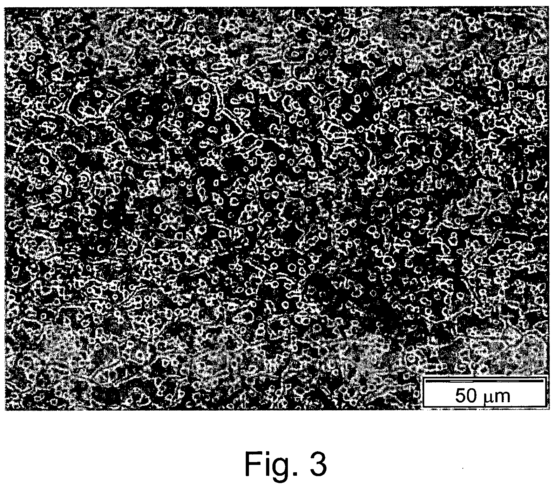

Figur 3 zeigt eine lichtmikroskopische Aufnahme der Silberlegierung nach Ätzen, Vergrößerung 500fach, (Schliff senkrecht zur Sputteroberfläche).

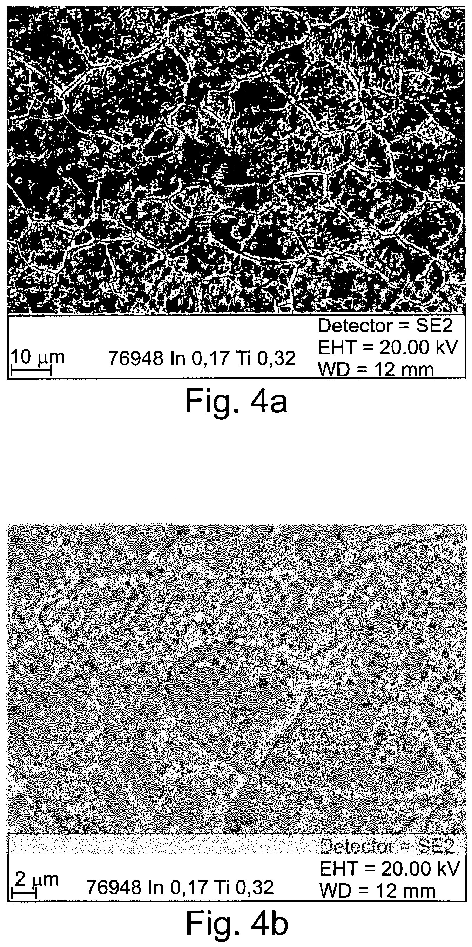

Die Figuren 4a und 4b zeigen in unterschiedlichen Vergrößerungen jeweils eine REM-Aufnahme der Silberlegierung nach dem Ätzen. Auf den Aufnahmen sind die Ti-haltigen Einschlüsse erkennbar. Wie die REM-Aufnahmen belegen, weisen die Ti-haltigen Einschlüsse eine sehr geringe mittlere Größe auf und sind über alle Körner in der Silberlegierung verteilt.

In der Tabelle 3 sind Röntgenbeugungsreflexintensitäten verschiedener Netzebenen für die Silberlegierung sowie für Silber als Referenzmaterial aufgelistet.

Tabelle 3 Intensitäten der Netzebenenreflexe für AgIn0,17Ti0,32

| Netzebene | 2 Theta | Silber (Soll) | AgIn0, 17Ti0,32 |
|---|---|---|---|
| 111 | 38,12 | 100 | 100 |
| 200 | 44,28 | 40 | 14,9 |
| 220 | 64,43 | 25 | 20,1 |
| 311 | 77,48 | 26 | 9,7 |
| 222 | 81,54 | 12 | 6,4 |

Die Silberlegierung wies folgende Eigenschaften auf:

| | |
|---|---|
| Mittlere Korngröße: | 13 $\mu$m |
| Mittleres Achsenverhältnis der Körner: | 51 % |
| Variation der Korngröße: | 30,5 % |
| Variation des Intensitätsverhältnisses zwischen dem zweitintensivsten Beugungsreflex und dem intensivsten Beugungsreflex: | 14,9% |
| Mittelwert der Titaneinschlüsse: | 0,5+/-0,06 Einschlüsse/$\mu$m$^2$ |

Abschließend wurde die Platte mechanisch wie Bsp. 1 bearbeitet und mit Indium gebondet.

Vergleichsbeispiel 1: Herstellung eines Sputtertargets bestehend aus einer Silberlegierung mit 0,5 Gew% Indium und 0,14 Gew% Titan

Verfahrenstechnisch wurde Vergleichsbeispiel 1 wie Beispiel 1 hergestellt, allerdings mit folgender Änderung: Abweichend von Beispiel 1 wurde bei Raumtemperatur mit 21 Stichen gewalzt.

Die Dicke des Formkörpers vor dem Walzen und nach jedem Walzschritt sowie die jeweilige Dickenreduktion und Umformrate sind beispielhaft für die Walzschritte 1-4 und 18-21 in der Tabelle 4 angegeben.

Tabelle 4: Dicke, Dickenreduktion und Umformrate im Vergleichsbeispiel 1

| Walzschritt | Dicke [mm] | Dickenreduktion [mm] | Dickenreduktion [%] | Umform-rate [l/s] |
|---|---|---|---|---|
| 0 (d.h. vor dem Walzen) | 155 | 0 | 0 | |
| 1 | 135 | 20 | 12,9 | 1,1 |
| 2 | 115 | 20 | 14,8 | 1,3 |
| 3 | 95 | 20 | 17,4 | 1,5 |
| 4 | 80 | 15 | 15,8 | 1,6 |
| 18 | 23 | 1 | 4,17 | 1,5 |
| 19 | 22 | 1 | 4,35 | 1,6 |
| 20 | 21 | 1 | 4,55 | 1,7 |
| 21 | 20 | 1 | 4,76 | 1,7 |

Nach dem letzten Walzschritt erhielt man eine Platte von ca. 2000*2000*20 mm. Diese Platte wurde zur Rekristallisation bei 600°C/2 Stunden lang geglüht.

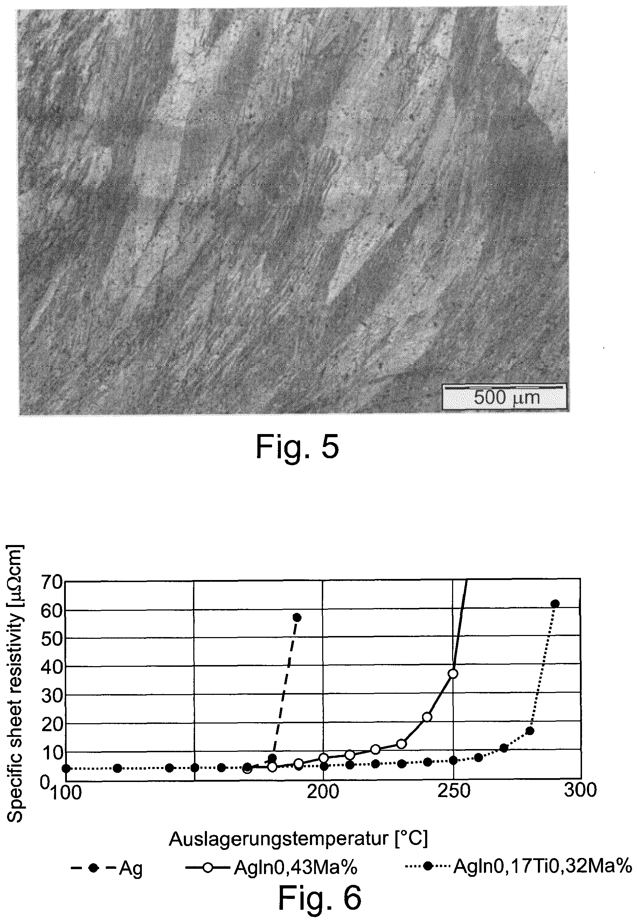

Figur 5 zeigt eine Lichtmikroskopie-Aufnahme der Silberlegierung nach Ätzen, 500-fache Vergrößerung.

Die Silberlegierung wies folgende Eigenschaften auf:

| | |
|---|---|
| Mittlere Korngröße: | 56 $\mu$m |
| Mittleres Achsenverhältnis der Körner: | <25 % |
| Variation der Korngröße: | >35 % |

Abschließend wurde die Platte für das Sputtern wie in Beispiel 1 mechanisch bearbeitet und mit Indium gebondet.

III. Sputtern von Schichten, Schichteigenschaften

Mit den hergestellten Sputtertargets der Grösse 488*80*10 mm³ der genannten Beispiele und Vergleichsbeispiele wurden 35 nm Beschichtungen auf ein natriumarmes Glassubstrat gesputtert (bei 500V DC, 0,2 A, 100W). Zusätzlich wurden weitere Vergleichsbeispiele 2 und 3 gewählt. Hier wurde reines Silber (Vergleichsbsp. 2) und eine Silber-Indium-Legierung mit einem Indiumgehalt von 0,43 Gew% (AgIn0,43; Vergleichsbeispiel 3) gewählt. Die Herstellung erfolgte in beiden Fällen analog Vergleichsbsp. 1. Die Korngrössen der Targets der Vergleichsbeispiele 2 und 3 wurden stichprobenartig beurteilt und lagen zwischen 5 und 80 $\mu$m. Das Korn war gleichachsig mit einem Achsenverhältnis zwischen 69 und 88%.

Für das Beispiel 1 zeigte die Schicht eine Schichtdickenabweichung von weniger als 2%, gemessen an 10 Punkten des Glassubstrats. Die Are-Rate des Targets lag deutlich unter 1 $\mu$arc/h.

Mit dem Sputtertarget des Vergleichsbeispiels 1 wurde ebenfalls eine Beschichtung auf ein Glassubstrat gesputtert (bei 500V DC, 0,2 A, 100W). Die Schicht zeigte eine Schichtdickenabweichung von mehr 8%, gemessen an 10 Punkten des Glassubstrats. Die Arcraten des Vergleichsbeispiels 1 lagen bei mehr als 50 $\mu$arc/h.

Für die mit den Sputtertargets des Beispiels 2 (Ag-In0,17-Ti0,32) und der Vergleichsbeispiele 2 (reines Silber) und 3 (Ag-In0,43; Abwesenheit von Titan) erhaltenen Beschichtungen wurde der Flächenwiderstand in Abhängigkeit von der Auslagerungstemperatur gemessen. Die Ergebnisse sind in Tabelle 5 aufgelistet.

Der Flächenwiderstand als Funktion der Temperatur ist auch in Figur 6 gezeigt. Wie der Legende der Figur 6 zu entnehmen ist, zeigt diese Figur den Flächenwiderstand als Funktion der Auslagerungstemperatur für Ag (Vergl.bsp. 2), AgIn0,43Ma% (Vergl.bsp. 3) und AgIn0,17Ti0,32Ma% (Bsp. 2).

Der Widerstand ist dabei ein Mass für die Agglomerationsneigung der Schicht nach Auslagerung (d.h. bei thermischer Belastung). Die mit dem erfindungsgemäßen Sputtertarget erzeugte Beschichtung zeigt eine sehr deutliche Verbesserung der Agglomerationsbeständigkeit. Erst bei einer Temperatur von mehr als 270°C zeigt sich eine Agglomeration bzw. ein Widerstandsanstieg auf Werte oberhalb von 10 $\mu\Omega$cm.

Tabelle 5: Flächenwiderstand (in $\mu\Omega$cm) nach thermischer Behandlung

| Temp. | Flächenwiderstand [$\mu\Omega$cm] AgIn0, 17Ti0,32 (Beschichtung erhalten mit dem Sputtertarget des Beispiels 2) | Flächenwiderstand [$\mu\Omega$cm] Ag (Beschichtung erhalten mit dem Sputtertarget des Vergleichsbeispiels 2) | Flächenwiderstand [$\mu\Omega$cm] AgIn0,43 (Beschichtung erhalten mit dem Sputtertarget des Vergleichsbeispiels 3) |
|---|---|---|---|
| 150 | 4,514 | 3,78 | - |
| 160 | 4,588 | 7,504 | - |
| 170 | 4,588 | 57,204 | 4,34 |
| 180 | 4,699 | - | 5,075 |
| 190 | 4,773 | - | 5,985 |
| 200 | 4,958 | - | 7,56 |
| 210 | 5,143 | - | 8,715 |
| 220 | 5,476 | - | 10,465 |
| 230 | 5,513 | - | 12,495 |
| 240 | 5,994 | - | 21,7 |
| 250 | 6,66 | - | 36,89 |
| 260 | 7,437 | - | 96,6 |
| 270 | 10,767 | - | 668,5 |
| 280 | 16,724 | - | - |
| 290 | 61,161 | - | - |

An Beschichtungen, die mit den Sputtertargets der Beispiele 1-2 sowie des Vergleichsbeispiels 3 hergestellt und gemäß der obigen Beschreibung einer thermischen Behandlung (Auslagerung) bei 300°C unterzogen wurden, erfolgte die Bestimmung der Reflexion über den Wellenlängenbereich des sichtbaren Lichts (380-780 nm).

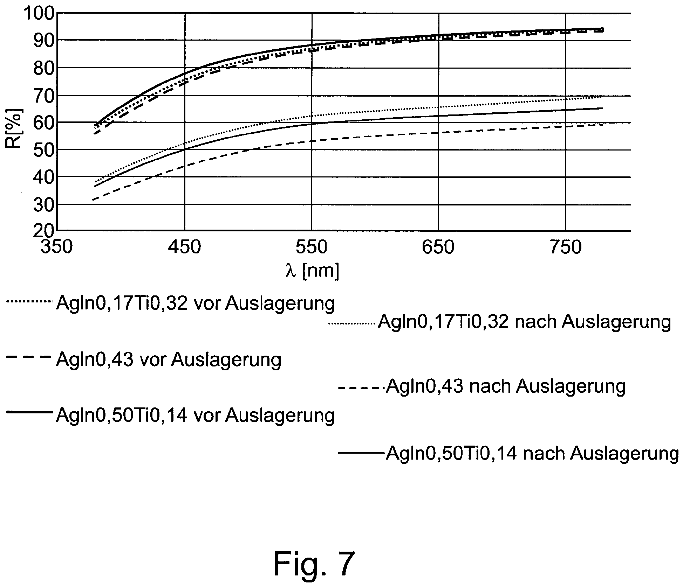

Die Ergebnisse werden in Figur 7 gezeigt. Wie der Legende der Figur 7 zu entnehmen ist, zeigt diese Figur die Reflexion über den Wellenlängenbereich des sichtbaren Lichts (380-780 nm) für folgende gesputterte Beschichtungen:

AgIn0,17Ti0,32 vor Auslagerung (obere gepunktete Linie),
AgIn0,43 vor Auslagerung (obere gestrichelte Linie)
AgIn0,50Ti0,14 vor Auslagerung (obere durchgezogene Linie)
AgIn0,17Ti0,32 nach Auslagerung (untere gepunktete Linie)
AgIn0,43 nach Auslagerung (untere gestrichelte Linie)
AgIn0,50Ti0,14 nach Auslagerung (untere durchgezogene Linie)

Tabelle 6 zeigt die Reflexionswerte bei 550 nm (in %) der jeweiligen Beschichtungen vor und nach dem Tempern bei 300°C.

Die abnehmende Reflektion als Folge der thermischen Behandlung ist auch hier ein Zeichen der zunehmenden Agglomeration. Bei der Beschichtung, die mit dem Sputtertarget des Vergleichsbeispiels 3 erhalten wurde, ist im Vergleich zu den Beschichtungen, die mit den erfindungsgemäßen Sputtertargets der Beispiele 1 und 2 erhalten wurden, eine deutlich stärkere Abnahme der Reflexion infolge der thermischen Behandlung zu beobachten.

Tabelle 6: Reflexion bei 550 nm (in %) vor und nach Tempern bei 300°C

| | Reflexion [%] bei 550 nm, vor Tempern | Reflexion [%] bei 550 nm, nach Tempern bei 300°C | Reduzierung % |
|---|---|---|---|
| Mit dem Sputtertarget des Beispiels 2 hergestellte Beschichtung | 87 | 62,6 | 28,0 |

(fortgesetzt)

|  | Reflexion [%] bei 550 nm, vor Tempern | Reflexion [%] bei 550 nm, nach Tempern bei 300°C | Reduzierung % |
|---|---|---|---|
| Mit dem Sputtertarget des Beispiels 1 hergestellte Beschichtung | 88,2 | 59,3 | 32,7 |
| Mit dem Sputtertarget des Vergleichsbeispiels 3 hergestellte Beschichtung | 86,2 | 53,1 | 38,4 |

Für die mit dem Sputtertarget des Beispiels 1 sowie dem Sputtertarget des Vergleichsbeispiels 3 abgeschiedenen Beschichtungen wurden die Oberflächenrauigkeiten vor dem Tempern sowie nach einem Tempern bei 300°C bestimmt. Die Ergebnisse werden in Tabelle 7 gezeigt.

In Tabelle 7 wird für die mittels AFM (atomic force microscope) Bruker Dimension 3100 gemessene Oberflächenrauigkeit der abgeschiedenen Schichten ersichtlich, dass bei gleichem Startwert für beide Beschichtungen von ca. 1,1 nm nach der Auslagerung bei 300°C die mit dem erfindungsgemäßen Sputtertarget erhaltene Schicht nur eine geringe Rauigkeitszunahme auf 1,3 nm erfährt, während sich der Rauigkeitswert bei der Beschichtung, die mit dem Sputtertarget des Vergleichsbeispiels 3 hergestellt wurde, mehr als verdoppelt. Dies zeigt auch das Oberflächenrauigkeitsverhältnis RR = $R_{an}/R_{av}$ mit $R_{av}$ = Ra vor Auslagerung und $R_{an}$ = Ra nach Auslagerung bei 300°C sehr deutlich.

Tabelle 7: Rauheit vor und nach Tempern bei 300°C

| Probe | $R_a$ [nm] | $R_q$ [nm] | RR |
|---|---|---|---|
| Beschichtung, Beispiel 1, Raumtemperatur | 1.1 | 1.4 | 1,18 |
| Beschichtung, Beispiel 1, Auslagerung 300°C | 1.3 | 2.4 | |
| Beschichtung, Vergleichsbeispiel 3, Raumtemperatur | 1.1 | 1.4 | 2,64 |
| Beschichtung, Vergleichsbeispiel 3, Auslagerung 300°C | 2.9 | 5.2 | |

Ein zusammenfassender Vergleich der einzelnen Beispiele und deren Sputter- und Schichteigenschaften in Tabelle 8 zeigt für die erfindungsgemäßen Sputtertargets besonders vorteilhafte Eigenschaften wie Reflexionsbeschichtungen mit sehr konstanter Schichtdicke. In Kombination mit der gleichmässigen und feinteiligen Titanverteilung kann für die erfindungsgemäßen Targets auch die Are-Rate sehr niedrig gehalten werden.

Tabelle 8 Bewertung der Sputter- und Schichteigenschaften

|  | Bsp 1 | Bsp 2 | Vergl. bsp. 1 | Vergl. bsp. 2 | Vergl. bsp. 3 |
|---|---|---|---|---|---|
| Sputtereigenschaften | ++ | ++ | -- | ++ | ++ |
| Schichtdickengleichmässigkeit | ++ | ++ | - | ++ | ++ |
| Schichtwiderstand nach thermischer Behandlung | ++ | ++ | | -- | -- |

**Patentansprüche**

1. Sputtertarget, bestehend aus einer Silberlegierung, die

  - ein erstes Element, ausgewählt aus Indium, Zinn, Antimon und Wismut, in einer Menge von 0,01-2 Gew%, bezogen auf das Gesamtgewicht der Silberlegierung, und
  - 0,01-2 Gew% Titan, bezogen auf das Gesamtgewicht der Silberlegierung, enthält, wobei der Rest Silber und unvermeidliche Verunreinigungen sind,,

  oder die

- ein erstes Element, ausgewählt aus Indium, Zinn, Antimon und Wismut, in einer Menge von 0,01-2 Gew%, bezogen auf das Gesamtgewicht der Silberlegierung,
- 0,01-2 Gew% Titan, bezogen auf das Gesamtgewicht der Silberlegierung, und
- ein oder mehrere zusätzliche Elemente, ausgewählt aus Indium, Zinn, Antimon und Wismuth, enthält, wobei der Rest Silber und unvermeidliche Verunreinigungen sind, unter der Maßgabe, dass sich das erste Element und das zusätzliche Element unterscheiden, wobei das zusätzliche Element oder jedes der zusätzlichen Elemente jeweils in einer Menge von 0,01 - 2 Gew%, bezogen auf das Gesamtgewicht der Silberlegierung, vorliegt,

wobei die Silberlegierung eine mittlere Korngröße von maximal 55 $\mu$m aufweist, **dadurch gekennzeichnet, dass**

- die Silberlegierung Ti-haltige Einschlüsse enthält, wobei die mittlere Größe der Ti-haltigen Einschlüsse kleiner 5 $\mu$m ist, wobei die mittlere Korngröße im Linienschnittverfahren (DIN EN ISO 643) nach folgender Gleichung bestimmt wurden:

$$M=(L*p)/(N*m) \text{ wobei}$$

L: Länge der Messlinie
p: Zahl der Messlinien
N: Zahl der geschnittenen Körper
m: Vergrößerung.

2. Sputtertarget nach einem der vorstehenden Ansprüche, wobei die Silberlegierung eine Variation der Korngröße von weniger als 35% aufweist, und/oder die Körner der Silberlegierung ein mittleres Achsenverhältnis von mindestens 40% aufweisen, wobei die Variation aus den Korngrössen M gemäß den beiden folgenden Gleichungen (als Wert A1 oder alternativ als Wert B1) bestimmt wird:

$$A1=(M_{max} - M_{ave})/(M_{ave} * 100)$$

$$B1=(M_{ave} - M_{min})/(M_{ave} * 100) \text{ mit}$$

$M_{max}$: Maximaler Wert der Korngrößen aller Messungen
$M_{min}$: Minimaler Wert der Korngrößen aller Messungen
$M_{ave}$: Mittlere Korngröße aller Messungen,

und das mittlere Achsenverhältnis der Mittelwert der Quotientenwerte von Korn-Höhe zu Korn-Breite ist, wobei die Korn-Höhe die maximale Abmessung eines Korns in Dickenrichtung (d.h. senkrecht zur Sputteroberfläche) des Sputtertargets und die Korn-Breite die maximale Abmessung eines Korns senkrecht zur Dickenrichtung bzw. parallel zur Sputteroberfläche der Körner ist.

3. Sputtertarget nach einem der vorstehenden Ansprüche, wobei die Silberlegierung Ti-haltige Einschlüsse enthält und pro $\mu$m$^2$ 0,1 - 5 Ti-haltige Einschlüsse vorliegen, wobei die Anzahl der Ti-haltigen Einschlüsse gemäß dem Flächenauszählverfahren nach DIN EN ISO 643 ist.

4. Sputtertarget nach einem der vorstehenden Ansprüche, wobei die Silberlegierung eine Variation des Intensitätsverhältnisses zwischen dem zweitintensivsten Röntgenbeugungsreflex und dem intensivsten Röntgenbeugungsreflex von weniger als 20% aufweist, wobei die Variation des Intensitätsverhältnisses gemäß den beiden folgenden Gleichungen (als Wert A2 oder alternativ als Wert B2) bestimmt wird:

$$A2=(R_{max} - R_{ave})/(R_{ave} * 100)$$

$$B2=(R_{ave} - R_{min})/(R_{ave} * 100)$$

mit

$R_{max}$: Maximaler Wert der Intensitätsverhältnisse
$R_{min}$: Minimaler Wert der Intensitätsverhältnisse
$R_{ave}$: Mittelwert der Intensitätsverhältniswerte R.

5. Verfahren zur Herstellung des Sputtertargets gemäß einem der Ansprüche 1-4, wobei man eine Schmelze, die Silber, ein erstes Element, das aus Indium, Zinn, Antimon und Wismuth ausgewählt ist, und Titan enthält, erstarren lässt, um einen festen Formkörper zu erhalten,

- der Formkörper auf eine Umformtemperatur von mindestens 200 °C erwärmt wird und dann mindestens einem Umformschritt unterzogen wird,
- und der Formkörper außerdem mindestens einer Rekristallisation unterzogen wird.

6. Verfahren nach Anspruch 5, wobei der Umformschritt ein Walzen, ein Schmieden, ein Stauchen, ein Strecken, eine Extrusion oder ein Pressen ist.

7. Verfahren nach Anspruch 6, wobei das Walzen ein Kreuzwalzen ist.

8. Verfahren nach einem der Ansprüche 5-7, wobei jeder Umformschritt bei einer Umformrate von mindestens 1 s$^{-1}$ durchgeführt wird.

9. Verfahren nach einem der Ansprüche 5-8, wobei der Formkörper mindestens einer dynamischen Rekristallisation und/oder mindestens einer statischen Rekristallisation unterzogen wird.

10. Verfahren nach Anspruch 9, wobei die dynamische Rekristallisation während des Umformens stattfindet, und/oder die statische Rekristallisation nach dem letzten Umformschritt erfolgt.

11. Verfahren nach einem der Ansprüche 5-10, wobei die Umformtemperatur, auf die der Formkörper vor dem ersten Umformschritt erwärmt wird, mindestens 600 °C beträgt, und/oder die statische Rekristallisation nach dem letzten Umformschritt durch ein Glühen bei einer Glühtemperatur von mindestens 650 °C erfolgt.

12. Das Verfahren nach einem der Ansprüche 9-11, wobei der Formkörper nach der statischen Rekristallisation abgeschreckt wird.

**Claims**

1. A sputter target made of a silver alloy comprising

- a first element selected from indium, tin, antimony, and bismuth, at a quantity of 0.01-2 wt% relative to the total weight of the silver alloy, and
- 0.01-2 wt% titanium relative to the total weight of the silver alloy, the remainder being silver and unavoidable contaminants,

or comprising

- a first element selected from indium, tin, antimony, and bismuth, at a quantity of 0.01-2 wt% relative to the total weight of the silver alloy,
- 0.01-2 wt% titanium relative to the total weight of the silver alloy, and
- one or more additional elements selected from indium, tin, antimony, and bismuth, the remainder being silver and unavoidable contaminants, under the stipulation that the first element and the additional element are different, the additional element or each of the additional elements each being present in a quantity of 0.01-2 wt% relative to the total weight of the silver alloy,

the silver alloy having an average grain size of no greater than 55 $\mu$m, **characterized in that**

- the silver alloy comprises inclusions comprising Ti, wherein the average size of the inclusions comprising Ti is less than 5 $\mu$m , wherein the average grain size from the linear intercept method (DIN EN ISO 643) has been determined according to the following equation:

$M=(L*p)/(N*m)$, where
L: length of the measurement line
p: number of measurement lines
N: number of intersected bodies
m: magnification.

2. The sputter target according to any one of the preceding claims, wherein the silver alloy has a variation in grain size of less than 35%, and/or the grains of the silver alloy have an average axis ratio of at least 40%, wherein the variation of the grain sizes M is determined according to the following two equations (as the value A1 or alternatively as the value B1):

$$A1=(M_{max} - M_{ave})/(M_{ave} * 100)$$

$$B1=(M_{ave} - M_{min})/(M_{ave} * 100),$$

where

$M_{max}$: maximum value of the grain sizes from all measurements
$M_{min}$: minimum value of the grain sizes from all measurements
$M_{ave}$: average grain size from all measurements,

and the average axis ratio is the average of the quotient values of grain height to grain width, wherein the grain height is the maximum dimension of a grain in the thickness direction (that is, perpendicular to the sputter surface) of the sputter target and the grain width is the maximum dimension of a grain perpendicular to the thickness direction, or parallel to the sputter surface of the grains.

3. The sputter target according to any one of the preceding claims, wherein the silver alloy comprises inclusions comprising Ti and 0.1-5 inclusions comprising Ti are present per $\mu m^2$, wherein the quantity of inclusions comprising Ti is in accordance with the area counting method of DIN EN ISO 643.

4. The sputter target according to any one of the preceding claims, wherein the silver alloy has less than 20% variation of the intensity ratio between the second most intensive X-ray diffraction reflex and the most intensive X-ray diffraction reflex, wherein the variation of the intensity ratio is determined according to the following two equations (as the value A2 or alternatively as the value B2):

$$A2=(R_{max}- R_{ave})/(R_{ave} * 100)$$

$$B2=(R_{ave} - R_{min})/(R_{ave} * 100)$$

where

$R_{max}$: maximum value of the intensity ratio
$R_{min}$: minimum value of the intensity ratio
$R_{ave}$: average of the intensity ratio values R.

5. A method for producing the sputter target according to any one of the claims 1-4, wherein a melt comprising silver; a first element selected from indium, tin, antimony, and bismuth; and titanium being allowed to solidify in order to obtain a solid molding,

- the molding being heated to a forming temperature of at least 200 °C and then subjected to at least one forming step,
- and the molding being further subjected to at least one recrystallization.

6. The method according to claim 5, wherein the forming step is a rolling, forging, upsetting, drawing, extruding, or pressing step.

7. The method according to claim 6, wherein the rolling is cross rolling.

8. The method according to any one of the claims 5 through 7, wherein each forming step is performed at a forming rate of at least 1 s$^{-1}$.

9. The method according to any one of the claims 5 through 8, wherein the molding is subjected to at least one dynamic recrystallization and/or at least one static recrystallization.

10. The method according to claim 9, wherein the dynamic recrystallization takes place during forming, and/or the static recrystallization takes place after the last forming step.

11. The method according to any one of the claims 5 through 10, wherein the forming temperature to which the molding is heated before the first forming step is at least 600 °C, and/or the static recrystallization takes place after the last forming step by annealing at an annealing temperature of at least 650 °C.

12. The method according to any one of the claims 9 through 11, wherein the molding is quenched after the static recrystallization.

**Revendications**

1. Cible de pulvérisation, constituée d'un alliage d'argent, qui contient

   - un premier élément, choisi parmi l'indium, l'étain, l'antimoine et le bismuth, en une quantité de 0,01 à 2 % en poids, par rapport au poids total de l'alliage d'argent, et
   - 0,01 à 2 % en poids de titane, par rapport au poids total de l'alliage d'argent, le reste étant de l'argent et des impuretés inévitables,

   ou qui contient

   - un premier élément, choisi parmi l'indium, l'étain, l'antimoine et le bismuth, en une quantité de 0,01 à 2 % en poids, par rapport au poids total de l'alliage d'argent,
   - 0,01 à 2 % en poids de titane, par rapport au poids total de l'alliage d'argent, et
   - un ou plusieurs éléments supplémentaires, choisis parmi l'indium, l'étain, l'antimoine et le bismuth, le reste étant de l'argent et des impuretés inévitables, à condition que le premier élément et l'élément supplémentaire soient différents, l'élément supplémentaire ou chacun des éléments supplémentaires étant à chaque fois présent en une quantité de 0,01 à 2 % en poids, par rapport au poids total de l'alliage d'argent,

   l'alliage d'argent présentant une taille de grain moyenne d'au plus 55 μm, **caractérisée en ce que**

   - l'alliage d'argent contient des inclusions contenant du Ti, la taille moyenne des inclusions contenant du Ti étant inférieure à 5 μm, la taille de grain moyenne ayant été déterminée par la méthode du segment intercepté linéaire (DIN EN ISO 643) selon l'équation suivante :

$$M=(L*p)/(N*m) \text{ où}$$

   L : longueur de la ligne de mesure
   p : nombre des lignes de mesure
   N : nombre des corps interceptés
   m : agrandissement.

2. Cible de pulvérisation selon l'une quelconque des revendications précédentes, dans laquelle l'alliage d'argent présente une variation de la taille de grain de moins de 35 %, et/ou les grains de l'alliage d'argent présentent un rapport axial moyen d'au moins 40 %, la variation des tailles de grain M étant déterminée selon les deux équations suivantes (en tant que valeur A1 ou en variante en tant que valeur B1) :

$$A1=(M_{max} - M_{ave})/(M_{ave} * 100)$$

$$B1=(M_{ave} - M_{min})/(M_{ave} * 100)$$

avec

$M_{max}$ : valeur maximale des tailles de grain de toutes les mesures
$M_{min}$ : valeur minimale des tailles de grain de toutes les mesures
$M_{ave}$ : taille de grain moyenne de toutes les mesures,

et le rapport axial moyen étant la valeur moyenne des valeurs de quotient de la hauteur de grain à la largeur de grain, la hauteur de grain étant la dimension maximale d'un grain dans la direction de l'épaisseur (c.-à-d. perpendiculairement à la surface de pulvérisation) de la cible de pulvérisation et la largeur de grain étant la dimension maximale d'un grain perpendiculairement à la direction de l'épaisseur ou parallèlement à la surface de pulvérisation des grains.

3. Cible de pulvérisation selon l'une quelconque des revendications précédentes, dans laquelle l'alliage d'argent contient des inclusions contenant du Ti et 0,1 à 5 inclusions contenant du Ti sont présentes par $\mu m^2$, le nombre des inclusions contenant du Ti étant déterminé par la méthode de dénombrement de surfaces selon DIN EN ISO 643.

4. Cible de pulvérisation selon l'une quelconque des revendications précédentes, dans laquelle l'alliage d'argent présente une variation du rapport d'intensité entre la deuxième réflexion de diffraction des rayons X la plus intense et la réflexion de diffraction des rayons X la plus intense de moins de 20 %, la variation du rapport d'intensité étant déterminée selon les deux équations suivantes (en tant que valeur A2 ou en variante en tant que valeur B2) :

$$A2=(R_{max}- R_{ave})/(R_{ave} * 100)$$

$$B2=(R_{ave} - R_{min})/(R_{ave} * 100)$$

avec

$R_{max}$ : valeur maximale du rapport d'intensité
$R_{min}$ : valeur minimale du rapport d'intensité
$R_{ave}$ : valeur moyenne des valeurs de rapport d'intensité R.

5. Procédé de fabrication de la cible de pulvérisation selon l'une quelconque des revendications 1 à 4, dans lequel une masse fondue, qui contient de l'argent, un premier élément, qui est choisi parmi l'indium, l'étain, l'antimoine et le bismuth, et du titane, est laissée durcir, afin d'obtenir un corps moulé solide,

- le corps moulé est porté à une température de formage d'au moins 200 °C, puis soumis à au moins une étape de formage,
- et le corps moulé est en outre soumis à au moins une recristallisation.

6. Procédé selon la revendication 5, dans lequel l'étape de formage est un laminage, un forgeage, un écrasement, un étirage, une extrusion ou un pressage.

7. Procédé selon la revendication 6, dans lequel le laminage est un laminage transversal.

8. Procédé selon l'une quelconque des revendications 5 à 7, dans lequel chaque étape de formage est réalisée à une vitesse de formage d'au moins 1 s$^{-1}$.

9. Procédé selon l'une quelconque des revendications 5 à 8, dans lequel le corps moulé est soumis à au moins une recristallisation dynamique et/ou au moins une recristallisation statique.

**10.** Procédé selon la revendication 9, dans lequel la recristallisation dynamique a lieu pendant le formage, et/ou la recristallisation statique a lieu après la dernière étape de formage.

**11.** Procédé selon l'une quelconque des revendications 5 à 10, dans lequel la température de formage, à laquelle le corps moulé est porté avant la première étape de formage, est d'au moins 600 °C, et/ou la recristallisation statique a lieu après la dernière étape de formage par un recuit à une température de recuit d'au moins 650 °C.

**12.** Procédé selon l'une quelconque des revendications 9 à 11, dans lequel le corps moulé est trempé après la recristallisation statique.

# Fig. 1

Fig. 2a

Fig. 2b

Fig. 3

Fig. 4a

Fig. 4b

Fig. 5

Auslagerungstemperatur [°C]

− ● −Ag　　—○—AgIn0,43Ma%　　····●····AgIn0,17Ti0,32Ma%

Fig. 6

············AgIn0,17Ti0,32 vor Auslagerung

··············AgIn0,17Ti0,32 nach Auslagerung

− − −AgIn0,43 vor Auslagerung

- - - -·AgIn0,43 nach Auslagerung

——AgIn0,50Ti0,14 vor Auslagerung

——AgIn0,50Ti0,14 nach Auslagerung

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1489193 A
- EP 2487274 A1
- US 7767041 B
- JP 2000109943 A
- US 20040048193 A
- EP 1736558 A
- US 7413618 B
- US 20050019203 A
- US 20080131308 A1
- JP 2004002929 A
- EP 1889930 A
- EP 1889931 A
- EP 1889932 A
- EP 18889933 A
- US 6896947 B
- US 5853872 A
- US 20070020138 A